# EUROPÄISCHE PATENTSCHRIFT

(11) **EP 0 852 069 B1**
(45) Veröffentlichungstag und Bekanntmachung des Hinweises auf die Patenterteilung: **09.12.2009**
(21) Anmeldenummer: 97929124.2
(22) Anmeldetag: 20.06.1997
(51) Int. Cl.: H01L 51/30, H01L 51/50

(54) **ELEKTRONENLEITENDE SCHICHT IN ORGANISCHEN, ELEKTROLUMINESZIERENDEN ANORDNUNGEN**
ELECTRON-CONDUCTING LAYER IN ORGANIC, ELECTROLUMINESCENT ARRANGEMENTS
COUCHE A CONDUCTION ELECTRONIQUE SITUEE DANS DES SYSTEMES ELECTROLUMINESCENTS ORGANIQUES

(30) Priorität: 17.07.1996 DE 19628719
(43) Veröffentlichungstag der Anmeldung: 08.07.1998
(73) Patentinhaber: Schmidt, Hans-Werner, Professor Dr., 95444 Bayreuth (DE)
(72) Erfinder: FINK, Ralph, D-95444 Bayreuth (DE); JONDA, Christoph, D-70195 Stuttgart (DE); SCHMIDT, Hans-Werner, D-95444 Bayreuth (DE); THELAKKAT, Mukundan, D-95448 Bayreuth (DE); WEHRMANN, Rolf, D-47800 Krefeld (DE); HUEPPAUFF, Martin, D-70563 Stuttgart (DE)
(74) Vertreter: Benz, Jürgen
(86) Internationale Anmeldenummer: PCT/DE1997/001269
(87) Internationale Veröffentlichungsnummer: WO 1998/004007

(56) Entgegenhaltungen:
- US-A- 5 077 142
- PATENT ABSTRACTS OF JAPAN vol. 095, no. 009, 31.Oktober 1995 & JP 07 157473 A (CHISSO CORP), 20.Juni 1995,
- APPLIED PHYSICS LETTERS, Bd. 66, Nr. 20, 15.Mai 1995, Seiten 2679-2681, XP000507576 ADACHI C ET AL: "MOLECULAR DESIGN OF HOLE TRANSPORT MATERIALS FOR OBTAINING HIGH DURABILITY IN ORGANIC ELECTROLUMINESCENT DIODES"
- APPLIED PHYSICS LETTERS, Bd. 69, Nr. 2, 8.Juli 1996, Seiten 224-226, XP000599648 SATOSHI HOSHINO ET AL: "ELECTROLUMINESCENCE FROM TRIPLET EXCITED STATES OF BENZOPHENONE"

## Beschreibung

### Stand der Technik

Die vorliegende Erfindung betrifft eine elektrolumineszierende Anordnung gemäß dem Oberbegriff des Hauptanspruchs.

Elektrolumineszierende Systeme zeichnen sich dadurch aus, daß bei Anlegen einer elektrischen Spannung und unter Stromfluß Licht ausgesendet wird. Derartige Systeme sind seit langem unter der Bezeichnung Leuchtdiode (LED, "Light Emitting Diode") bekannt. Die Lichtemission wird dadurch hervorgerufen, daß positive Ladungsträger (im folgenden als "Löcher" bezeichnet) und negative Ladungsträger (Elektronen) unter Aussendung von Licht miteinander rekombinieren. Die in der Technik eingesetzten LED's bestehen im allgemeinen aus anorganischen Halbleitermaterialien. Bekannt sind außerdem elektrolumineszierende Systeme, deren wesentliche Bestandteile aus organischen Verbindungen bestehen. Die aus organischen Verbindungen aufgebauten LED's weisen eine oder mehrere dünne Schichten aus organischen Ladungstransportverbindungen auf. Die WO 90/13148 beschreibt elektrolumineszierende Anordnungen, in denen Poly-(p-phenylenvinylen) eingesetzt wird. Die organische Verbindung übernimmt die Funktion der Lichtemission und der Elektronen- sowie der Löcherleitung.

### Vorteile der Erfindung

Die elektrolumineszierende Anordnung gemäß Hauptanspruch weist den Vorteil auf, daß eine neue Klasse von Verbindungen zum Einsatz in elektronenleitenden Schichten in LED's bereitgestellt wird, die bisher für diesen Zweck noch nicht eingesetzt wurden. Das Spektrum an zur Verfügung stehenden organischen Verbindungen für die Herstellung elektrolumineszierender Anordnungen wird daher erheblich erweitert. Die erfindungsgemäß eingesetzten Triazin-Grundkörper aufweisenden Verbindungen zeichnen sich dadurch aus, daß sie bevorzugt Elektronen leiten und Löcher blockieren. Elektrolumineszierende Anordnungen mit einer erfindungsgemäßen elektronenleitenden Schicht weisen eine erheblich höhere Lichtintensität auf als Anordnungen ohne diese Schicht.

Die Erfindung betrifft eine elektrolumineszierende Anordnung aus mindestens zwei Elektroden und einem mindestens eine elektronenleitende . Schicht umfassenden lichtemittierenden Schichtsystem, wobei die elektronenleitende Schicht mindestens eine einen Triazin-Grundkörper aufweisende Verbindung enthält.

Im Zusammenhang mit der vorliegenden Erfindung wird unter einem TriazinGrundkörper eine stickstoffhaltige Heterozyklenverbindung der Summenformel C₃H₃N₃ mit drei Stickstoffatomen in einem sechsgliedrigen Ring verstanden.

Die Verbindung weist eine Struktur der allgemeinen Formel 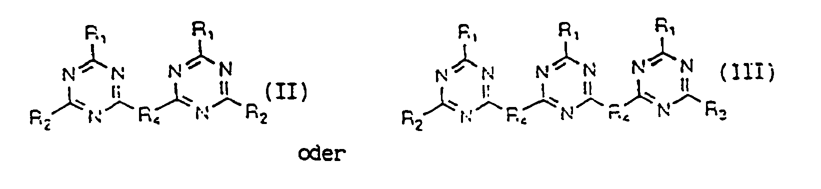 auf, in der die organischen Reste R₁, R₂ und R₃ aus der nachstehenden Gruppe von Verbindungen ausgewählt sind: 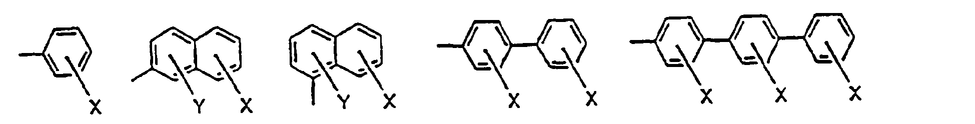 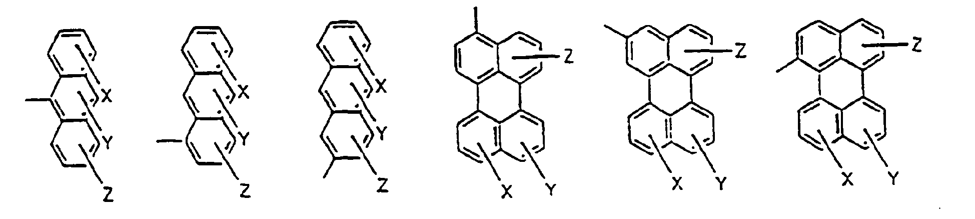 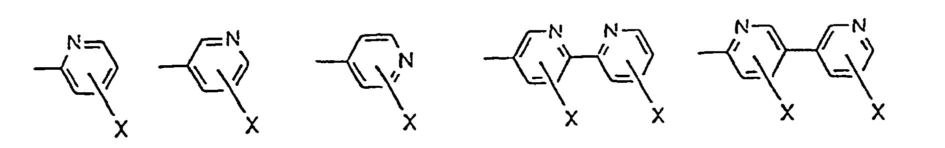 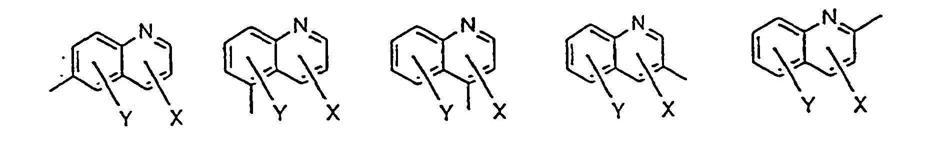 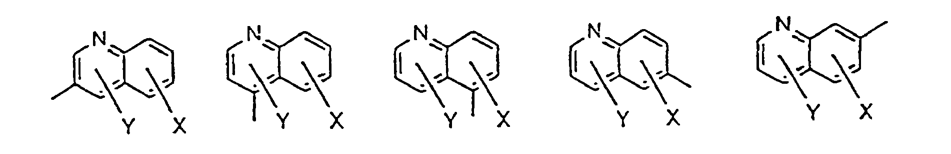 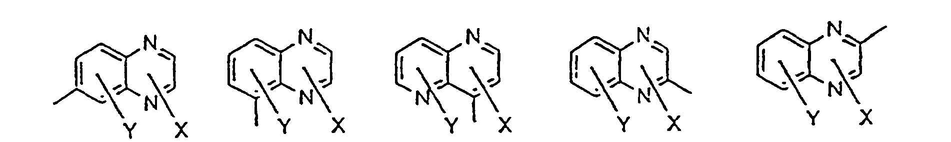 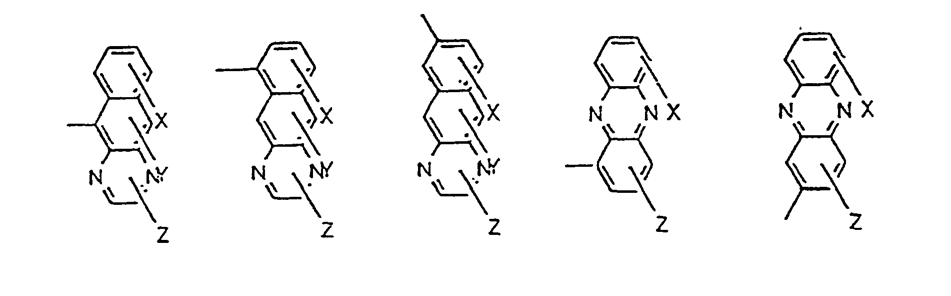 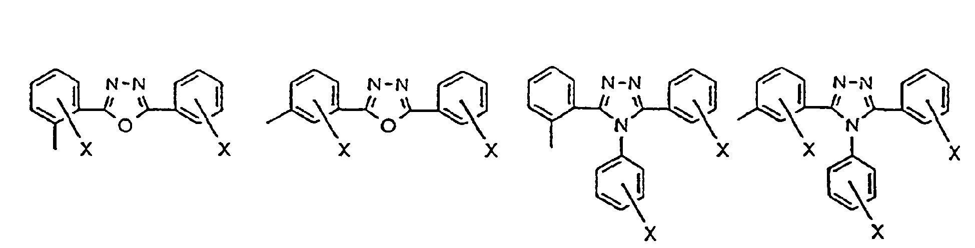 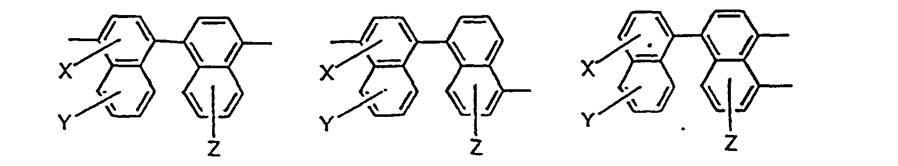 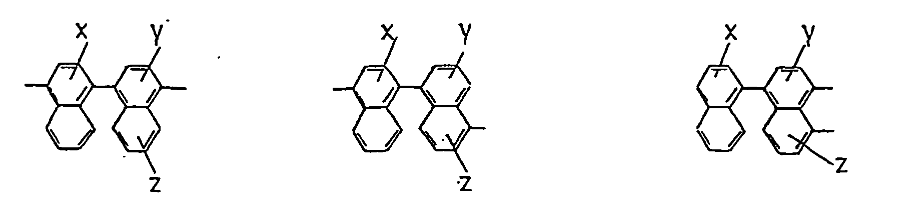 und wobei die Substituenten X, Y, Z aus der Gruppe bestehend aus Wasserstoff, Halogen-, Sauerstoff-, Schwefelatomen, Cyanoalkyl-, Alkyl-, Alkoxy-, Arylalkyl-, Sulfoxyl-, Sulfonyl- und TrifluormethylGruppen ausgewählt sind und wobei der Rest R₄ aus der nachstehenden Gruppe von Verbindungen ausgewählt ist: 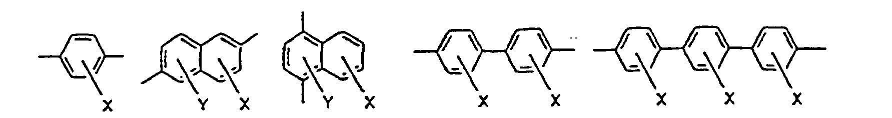 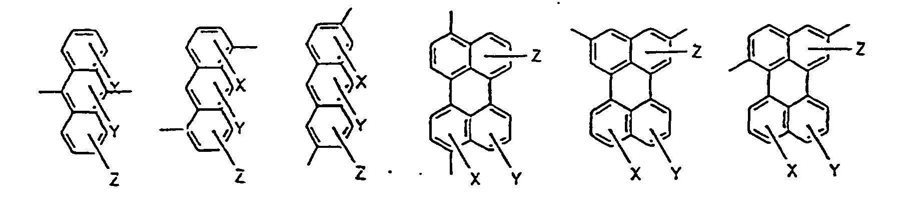 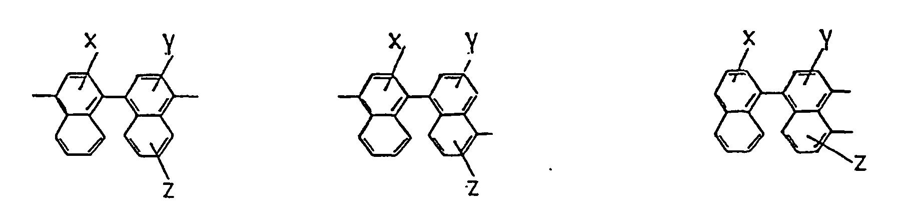 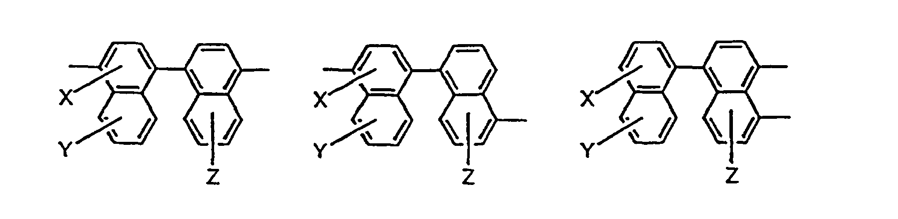 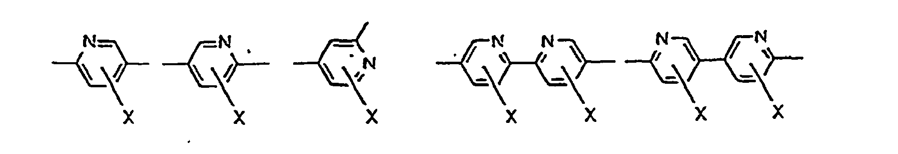 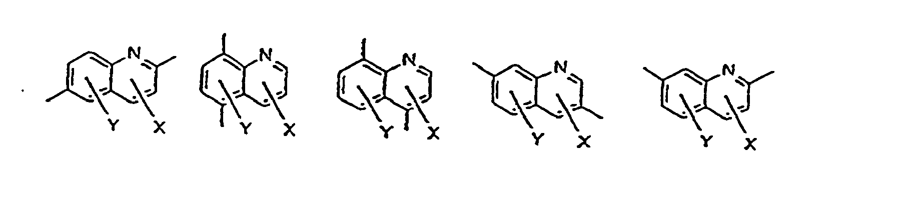 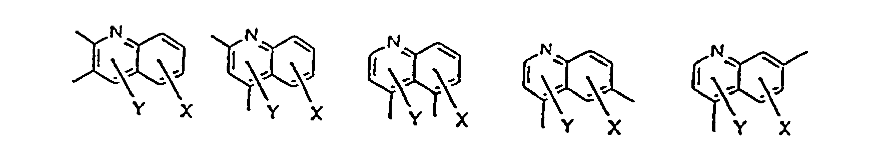 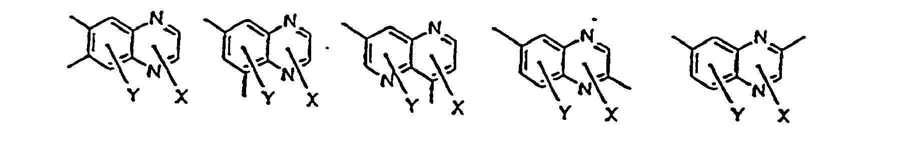 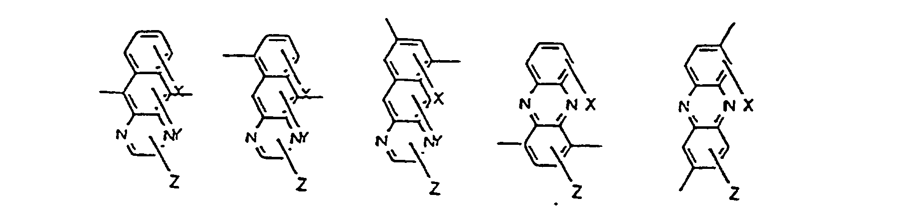 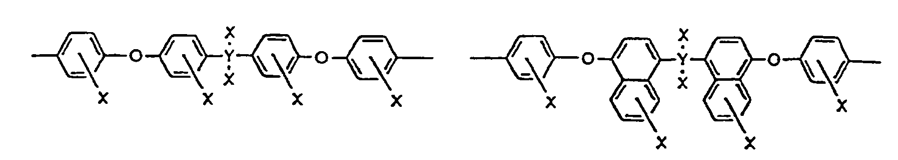 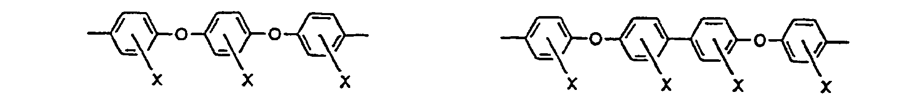 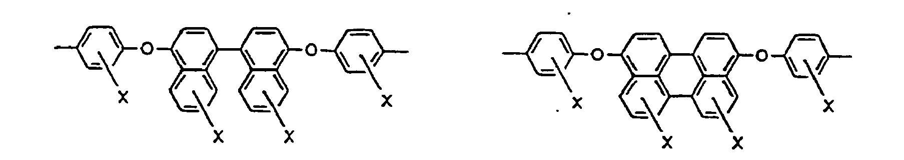 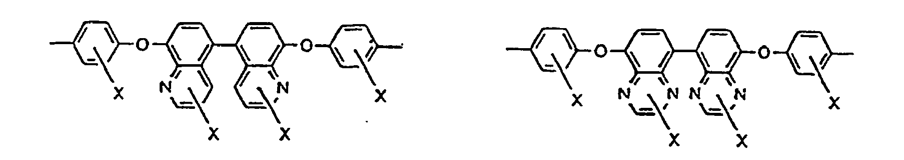 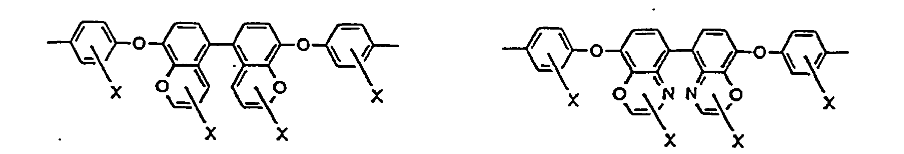 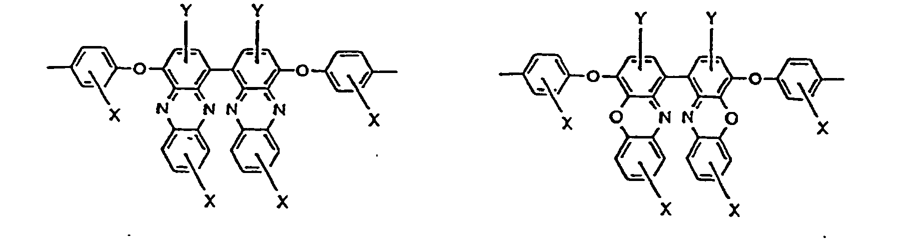 Neben den abgebildeten Verknüpfungsstellen, wie zum Beispiel 1,4-Substitution, sind selbstverständlich auch alle anderen Verknüpfungen von R₄ möglich und damit Gegenstand der vorliegenden Erfindung.

In besonders bevorzugter Ausführungsform weist die elektrolumineszierende Anordnung der vorliegenden Erfindung mehrere Schichten, insbesondere eine auf einem Substrat aufgebrachte Anode, mindestens eine auf der Anode aufgebrachte lochinjizierende Schicht, mindestens eine auf der lochinjizierenden Schicht aufgebrachte lochleitende Schicht, mindestens eine auf der lochleitenden Schicht aufgebrachte Emitterschicht, mindestens eine auf der Emitterschicht aufgebrachte elektronenleitende Schicht, mindestens eine auf der elektronenleitenden Schicht aufgebrachte elektroneninjizierende Schicht und eine auf der elektroneninjizierenden Schicht aufgebrachte Kathode auf, wobei dieses Substrat-Schichtensystem vorzugsweise eingekapselt ist. Selbstverständlich ist es auch möglich, daß einzelne der vorgenannten Schichten nicht vorhanden sind, sondern daß einzelne oder alle Funktionen einschließlich der Lichtemission in einer oder wenigen Schichten lokalisiert sind. Die elektronenleitende Schicht der vorliegenden Erfindung kann also auch andere Funktionen ausüben, beispielsweise elektrolumineszierend wirken.

Eine der Elektroden kann transparent oder semitransparent sein. Bevorzugt wird eine transparente, elektrisch leitfähige Anode aus einem Metalloxid, zum Beispiel Indium-Zinnoxid (ITO) eingesetzt.

Die Kathode wird bevorzugt aus Metallen wie Mg, Ag, Al, In etc. hergestellt, die eine gute Elektroneninjektion gewährleisten.

Zur Herstellung der erfindungsgemäßen Anordnungen können die erfindungsgemäß verwendeten Verbindungen beispielsweise mittels Vakuumverdampfen auf die Elektroden oder gegebenenfalls auf andere Schichten aufgebracht werden.

### Ausführungsbeispiele

Die Erfindung wird anhand von Ausführungsbeispielen und dazugehöriger Figuren näher erläutert.

### Es zeigen

- Figur 1: den schematischen Aufbau einer elektrolumineszierenden Anordnung der vorliegenden Erfindung,
- Figur 2: das Ergebnis eines Vergleichs der Licht-intensität einer Anordnung gemäß Stand der Technik (A) und der Erfindung (B).
- Figur 3: das Ergebnis eines weiteren Vergleichs der Lichtintensität einer Anordnung gemäß Stand der Technik (A) und der Erfindung (B).

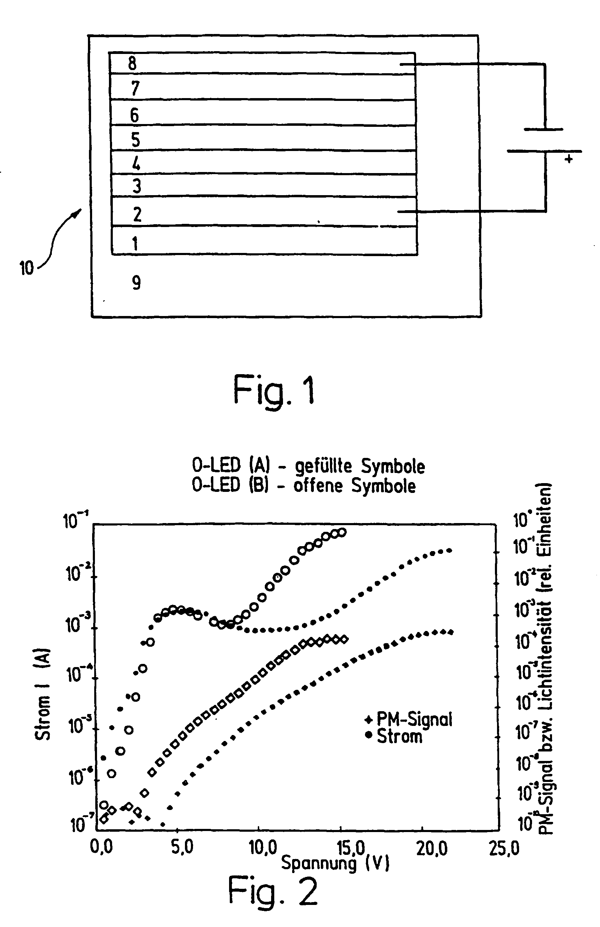

Die Figur 1 erläutert schematisch den Aufbau einer organischen Leuchtdiode (O-LED) 10 gemäß vorliegender Erfindung.

Auf dem Substrat 1 ist eine Anode 2 angeordnet, über der eine lochinjizierende Schicht 3 aufgebracht ist. Diese ist von einer lochleitenden Schicht 4 und einer darauf angeordneten Lichtemitterschicht 5 überdeckt. Auf der Lichtemitterschicht 5 befindet sich eine elektronenleitende Schicht 6 sowie eine über dieser angeordnete elektroneninjizierende Schicht 7. Die elektronenleitende Schicht 6 weist eine Verbindung mit einer Struktur gemäß nachstehender Formel (IV) auf, die in vorteilhafter Weise bevorzugt Elektronen leitet und Löcher blockiert. Über diesem Schichtensystem ist eine Kathode 8 angeordnet. Die gesamte elektrolumineszierende Anordnung 10 ist durch die Umhüllung 9 verkapselt.

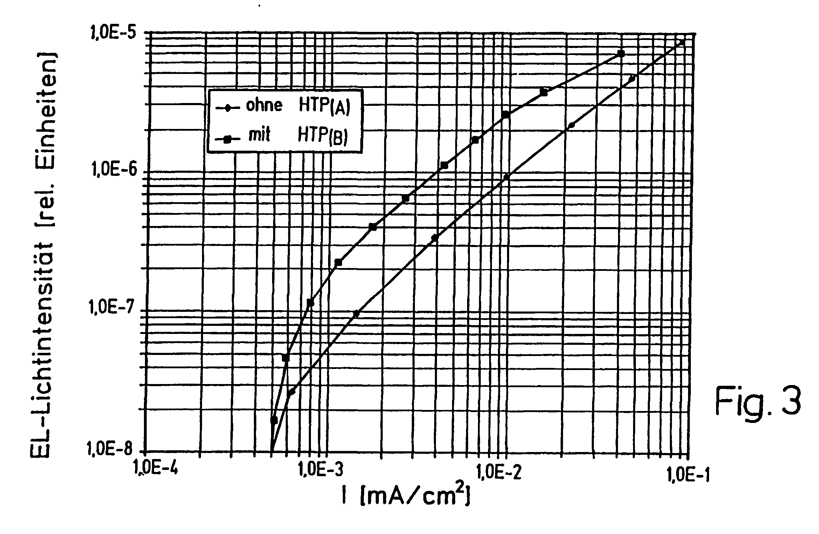

Figur 2 und 3 zeigen die Ergebnisse von Lichtintensitätsmessungen je einer Anordnung (A) gemäß Stand der Technik und einer erfindungsgemäßen Anordnung (B). Figur 2 zeigt das Ergebnis bei der Verwendung von Beispiel 1 und Figur 3 das Ergebnis bei der Verwendung von Beispiel 2.

### Herstellung der Anordnungen:

### Beispiel 1:

Zur Herstellung der Leuchtdiode (A), also der Anordnung gemäß dem Stande der Technik, wurde auf einem gereinigten mit Indium-Zinnoxid (ITO) beschichteten Substrat aus Glas eine 80 nm dicke Schicht aus dem lochleitenden Material 4,4'-Dimethoxy-TPD (DTPD) mittels Vakuumverdampfung aufgebracht. Auf diese Schicht wurde eine 40 nm dicke Schicht aus dem Emitter Alq₃ (Aluminium (III)-tris-(8-hydroxy-chinolat)) mittels Vakuumverdampfung aufgebracht. Auf die Emitter-Schicht wurde eine Aluminium-Kathode aufgedampft.

Zur Herstellung der die erfindungsgemäß zu verwendenden Triazin-Grundkörper enthaltenen Verbindung (Anordnung (B)) wurde die vorstehende Anordnung (A) hergestellt, wobei jedoch vor der abschließenden Bedampfung mit Aluminium zur Herstellung der Kathode eine elektronenleitende Schicht aus HTP [4,4'-(hexafluoroisopropyliden)-bis-(4-phenoxy-phenyl-4-(4,6-diphenyl-1,3,5 triazin))] einer einen Triazin-Grundkörper enthaltenen Verbindung folgender Formel 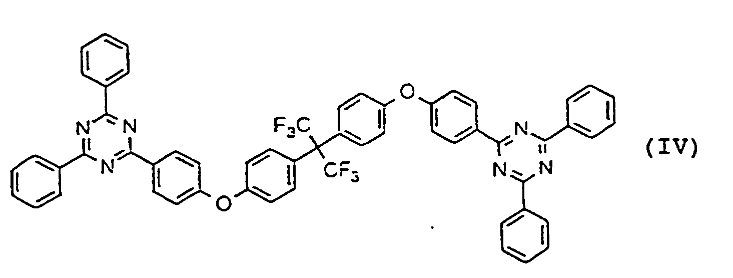 in einer Dicke von 30 nm aufgedampft wurde. Der Aufbau der elektrolumineszierenden Anordnung gemäß Stand der Technik (A) und der Erfindung (B) stellt sich also folgendermaßen dar:
(A) Glassubstrat/ITO/4,4'-Dimethoxy-TPD (80nm)/ Alq₃ (40nm)/ Al-Kathode
(B) Glassubstrat/ITO/4,4'-Dimethoxy-TPD (80nm)/ Alq₃ (40nm)/ HTP (30nm)/ Al-Kathode.

Die folgende Tabelle und die Figur 2 verdeutlichen die Vorteile organischer Leuchtdioden (B) mit der den erfindungsgemäßen Triazin-Grundkörper aufweisenden elektronenleitenden Schicht im Vergleich zu herkömmlichen organischen Leuchtdioden (A), denen diese Schicht fehlt.

| | Iₘₐₓ [A] | Leuchtstärke [Cd/m²] |
|---|---|---|
| (A) ITO/D-TPD/Alq₃ | 36 | 250 |
| (B) ITO/D-TPD/Alq₃/HTP | 26 | 600 |

Die Tabelle sowie die Figur 2 zeigen deutlich, daß die die erfindungsgemäße zusätzliche elektronenleitende Schicht enthaltende Anordnung (B) etwa um den Faktor 3 effizienter ist als das System gemäß dem Stande der Technik (A).

### Beispiel 2:

Zur Herstellung der Leuchtdiode (A), also der Anordnung gemäß Stand der Technik, wurde auf einem gereinigten Indium-Zinnoxid (ITO) beschichteten Substrat aus Glas eine Schicht aus dem lochleitenden Material [4-[bis(4-ethylphenyl)aminophenyl-N,N,N',N'-tetrakis(4-ethyl-phenyl)-1,1':3',1"-terphenyl]-4,4"diamin (EFTP) gemäß folgender Formel: 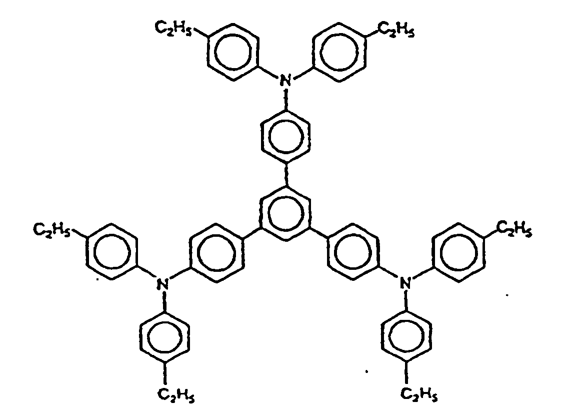 aufgebracht. Das hochleitende Material EFTP wurde aus einer 2%igen Lösung (Lösungsmittel: Cyclohexanon) mit 1750 U/min aufgeschleudert. Die Schichtdecke betrug 40 nm.

Auf diese Schicht wurde eine 60 nm dicke Schicht aus dem Emitter Alq₃ (Aluminium(III)-tris-(8-hydroxychinolat)) mittels Vakuumverdampfung aufgebracht, Auf die Emitter-Schicht wurde eine MgAg-Kathode (10:1 at%) aufgedampft. Die MgAg-Legierung wurde mittels Kodeposition aus zwei thermischen Verdampferquellen aufgedampft.

Zur Herstellung der die erfindungsgemäß zu verwendenden Triazin-Grundkörper enthaltenen Verbindung (Anordnung (B)) wurde die vorstehende Anordnung (A) hergestellt, wobei jedoch vor der abschließenden Bedampfung mit MgAg zur Herstellung der Kathode eine elektronenleitende Schicht aus HTP, einer einen Triazin-Grundkörper enthaltenen Verbindung mit folgender Formel 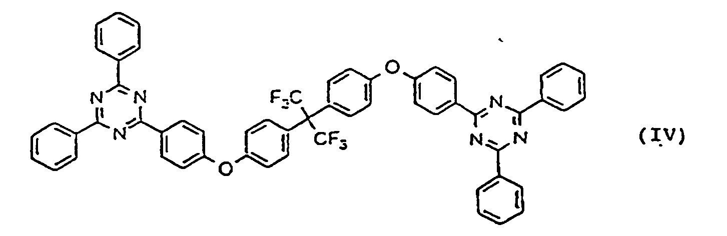 in einer Dicke von 47 nm aufgedampft wurde. Der Aufbau der elektrolumineszierenden Anordnung gemäß Stand der Technik (A) und der Erfindung (B) stellt sich also folgendermaßen dar:
(A) Glassubstrat/ITO/EFTP (40nm)/ Alq₃ (60nm)/MgAg-Kathode.
(B) Glassubstrat/ITO/EFTP (40 nm)/ Alq₃ (50nm)/HTP (47nm)/MgAg-Kathode.

Die folgende Tabelle und die Figur 3 verdeutlichen die Vorteile organischer Leuchtdioden (B) mit der den erfindungsgemäßen Triazin-Grundkörper aufweisenden elektronenleitenden Schicht im Vergleich zu organische Leuchtdioden (A), denen diese Schicht fehlt.

| | I (A/cm²) | Leuchtstärke [Cd/m²] |
|---|---|---|
| (A) ITO/EFTP/Alq₃/MgAg | 0,01 | 280 |
| (B) ITO/EFTP/Alq₃/HTP/MgAg | 0,01 | 760 |

Die Tabelle sowie die Figur 3 zeigen deutlich, daß die die erfindungsgemäße zusätzliche elektronenleitende Schicht enthaltene Anordnung (B) etwa um den Faktor 3 effizienter ist als das System gemäß dem Stande der Technik (A).

## Patentansprüche

1. Elektrolumineszierende Anordnung aus mindestens zwei Elektroden und einem mindestens eine elektronenleitende Schicht umfassenden lichtemittierenden Schichtsystem, wobei die elektronenleitende Schicht mindestens eine einen Triazin-Grundkörper aufweisende Verbindung enthält oder aus dieser besteht, **dadurch gekennzeichnet, dass** die Verbindung eine Struktur der allgemeinen Formel (II) oder (III) aufweist, 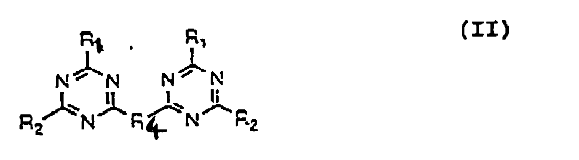 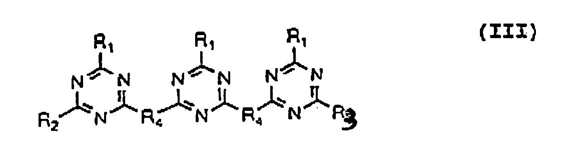 in denen die organischen Reste R₁, R₂ und R₃ aus der nachstehenden Gruppe von Verbindungen ausgewählt sind: 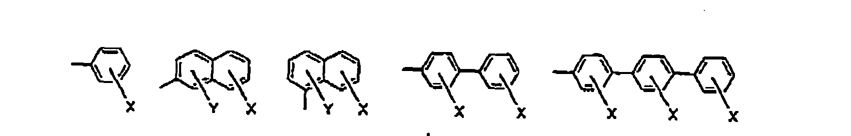 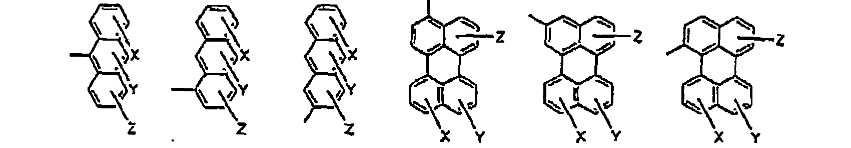 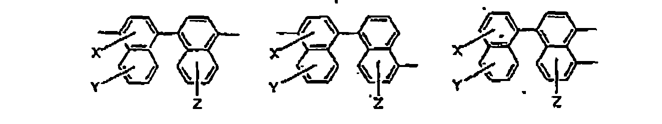 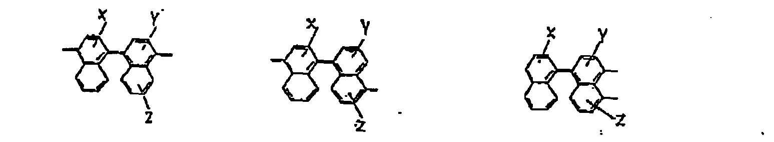 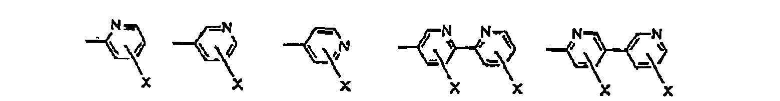 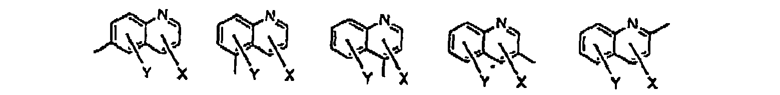 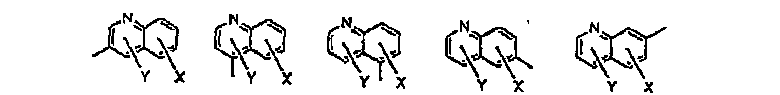 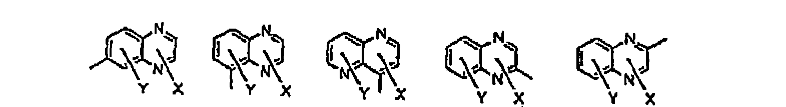 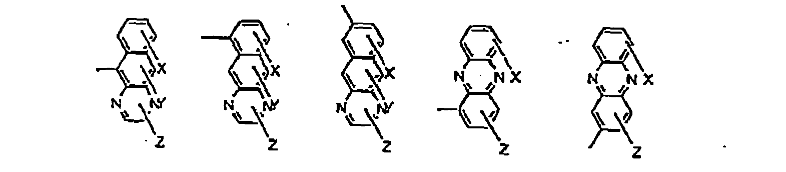 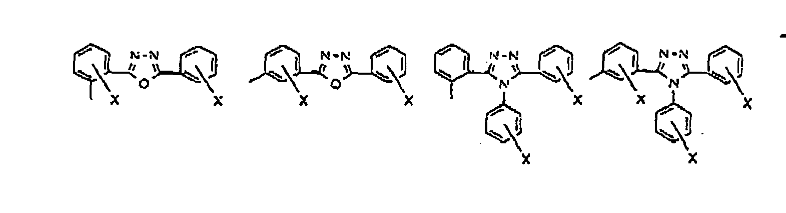 und wobei R₄ aus der nachstehenden Gruppe von Verbindungen ausgewählt ist: 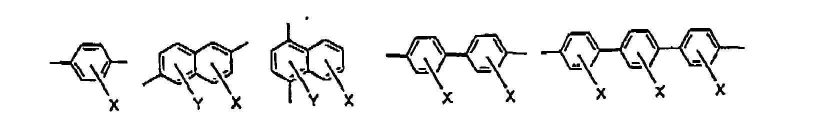 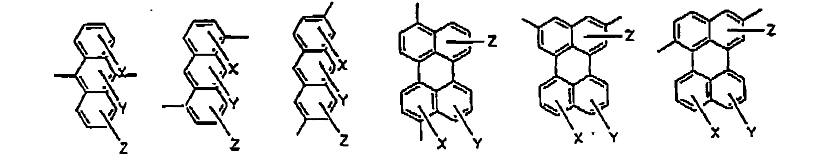 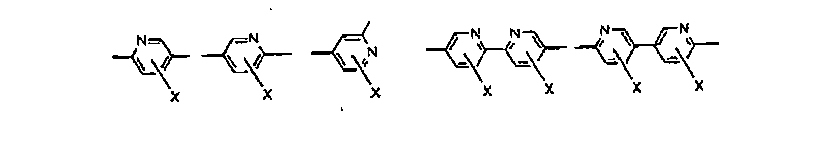 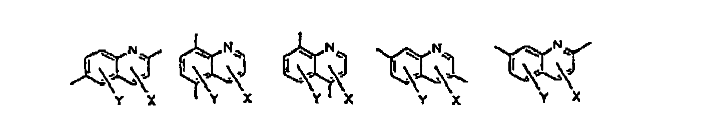 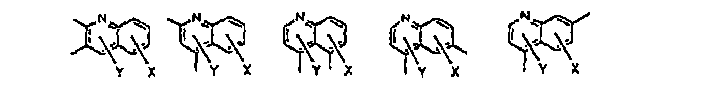 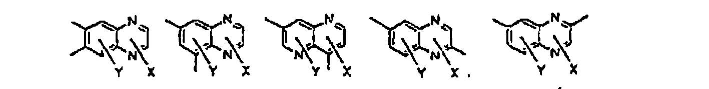 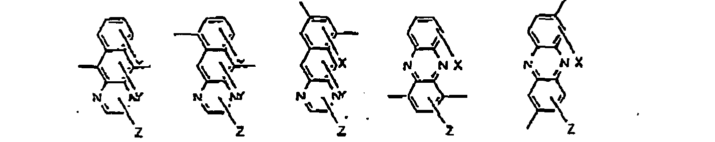 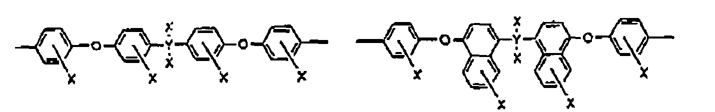 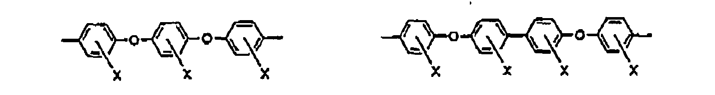 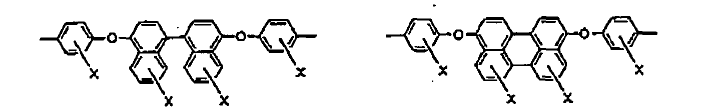 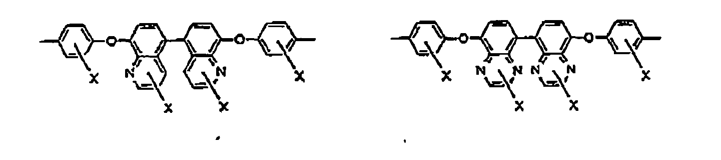 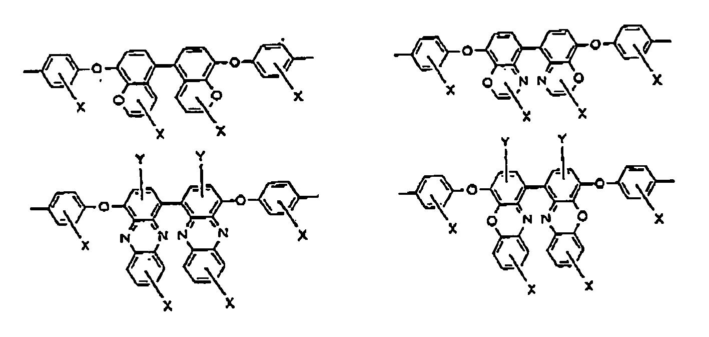 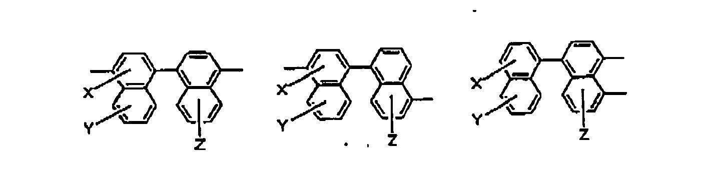 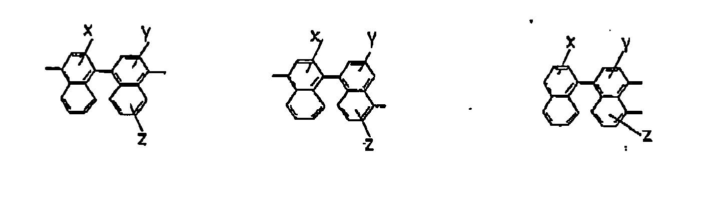 und wobei die Substituenten X, Y, Z aus der Gruppe bestehend aus Wasserstoff, Halogen-, Sauerstoff-, Schwefelatomen, Cyanoalkyl-, Alkyl-, Alkoxy-, Arylalkyl-, Sulfoxyl-, Sulfonyl- und TrifluormethylGruppen ausgewählt sind.

2. Anordnung nach Anspruch 1, **dadurch gekennzeichnet, dass** die Verbindung eine Struktur der folgenden Formel 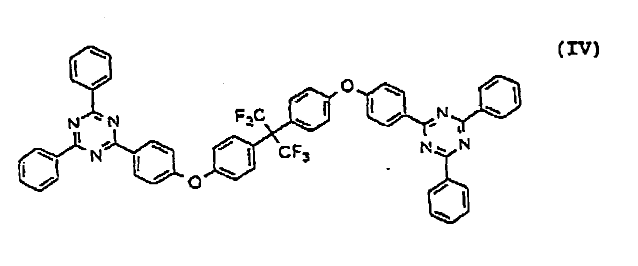 aufweist.

3. Anordnung nach einem der vorhergehenden Ansprüche, **dadurch gekennzeichnet, dass** das lichtemittierende Schichtsystem aus drei Schichten besteht.

4. Anordnung nach einem der vorhergehenden Ansprüche, **dadurch gekennzeichnet, dass** das lichtemittierende Schichtsystem aus einer löcherleitenden Schicht, einer Emitterschicht und einer elektronenleitenden Schicht besteht.

5. Anordnung nach einem der vorhergehenden Ansprüche, **dadurch gekennzeichnet, dass** die löcherleitende Schicht 4,4'-Dimethoxy-TPD (D TPD) der folgenden Formel 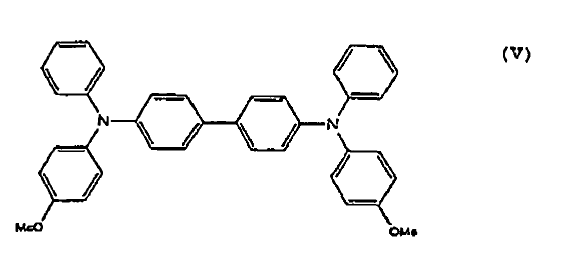 enthält oder aus diesem besteht.

6. Anordnung nach einem der vorhergehenden Ansprüche, **dadurch gekennzeichnet, dass** die löcherleitende Schicht EFTP der folgenden Formel 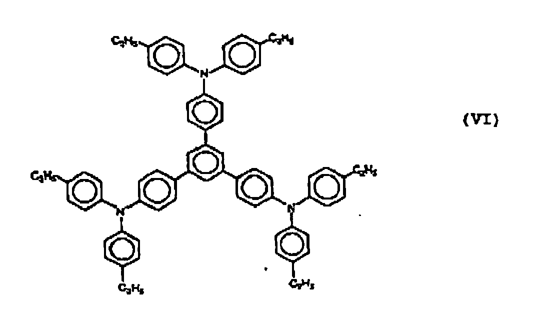 enthält oder aus diesem besteht.

7. Anordnung nach einem der vorhergehenden Ansprüche, **dadurch gekennzeichnet, dass** die Emitterschicht eine photolumineszierende Substanz, insbesondere einen Fluoreszenzfarbstoff enthält oder aus dieser besteht.

8. Anordnung nach einem der vorhergehenden Ansprüche, **dadurch gekennzeichnet, dass** die Emitterschicht Aluminium(III)-tris-(8-hydroxychinolat) der folgenden Formel 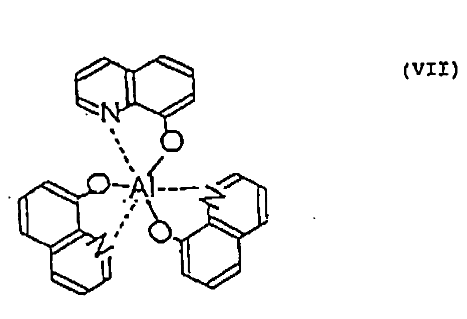 enthält oder aus diesem besteht.

9. Anordnung nach einem der vorhergehenden Ansprüche, **dadurch gekennzeichnet, dass** das Schichtsystem auf einem Substrat ist.

10. Anordnung nach einem der vorhergehenden Ansprüche, **dadurch gekennzeichnet, dass** das Substrat ein Glassubstrat ist.

11. Anordnung nach einem der vorhergehenden Ansprüche, **dadurch gekennzeichnet, dass** die Anode Indium-Zinnoxid enthält oder aus dieser besteht.

12. Anordnung nach einem der vorhergehenden Ansprüche, **dadurch gekennzeichnet, dass** die Kathode Aluminium und/oder Mg/Ag und/oder Indium enthält oder aus diesem besteht.

## Claims

1. Electroluminescent arrangement comprising at least two electrodes and a light-emitting layer system comprising at least one electron-conducting layer, where the electron-conducting layer comprises or consists of at least one compound having a triazine skeleton, **characterised in that** the compound has a structure of the general formula (II) or (III): 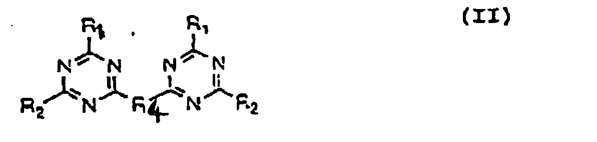 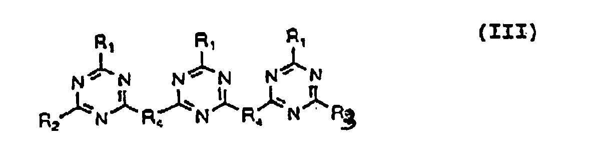 in which the organic radicals R₁, R₂ and R₃ are selected from the following group of compounds: 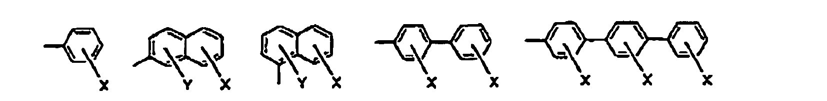 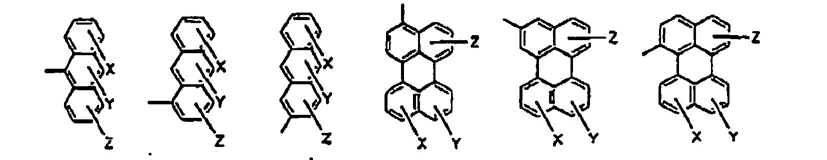 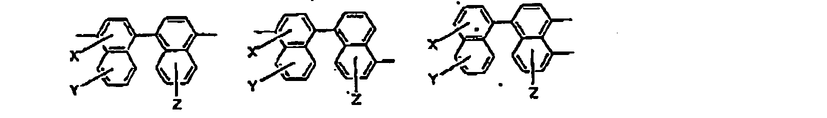 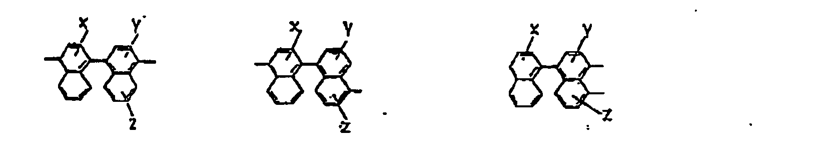 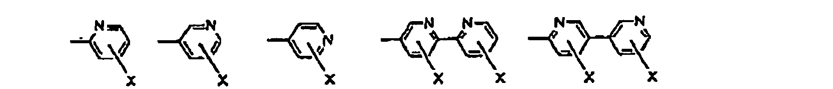 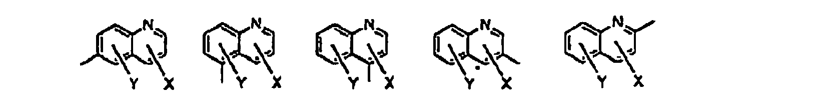 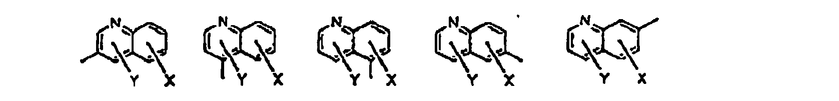 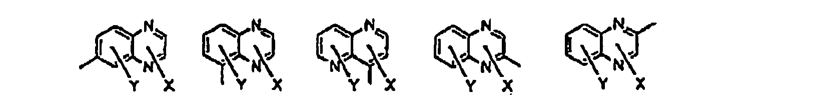 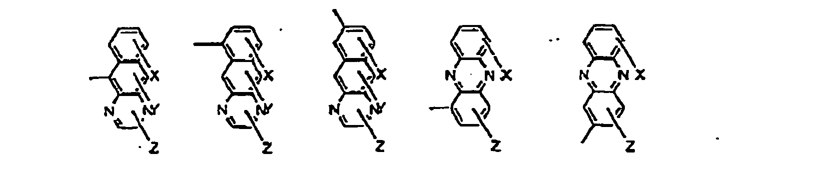 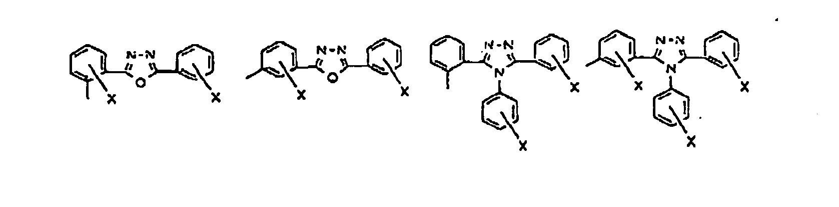 and where R₄ is selected from the following group of compounds: 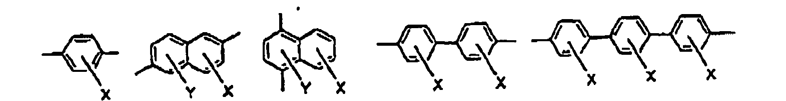 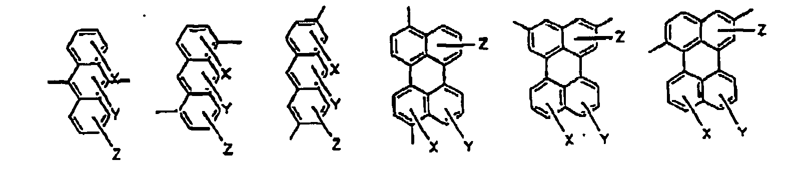 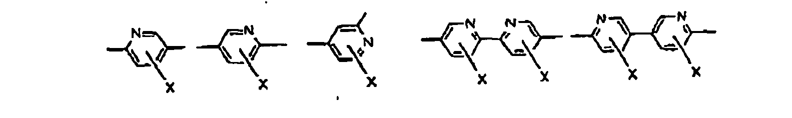 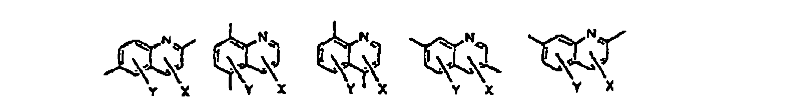 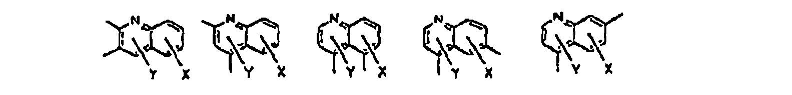 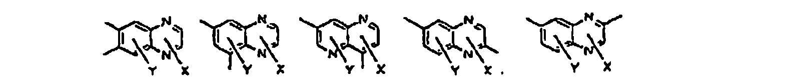 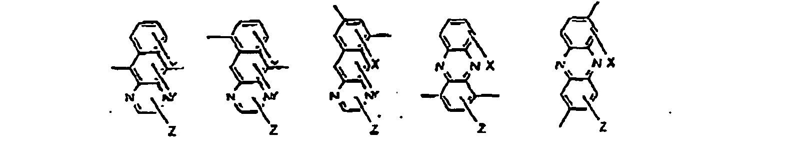 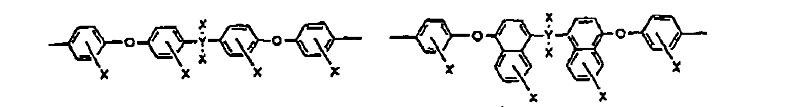 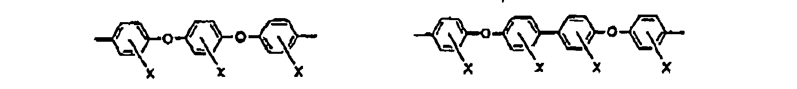 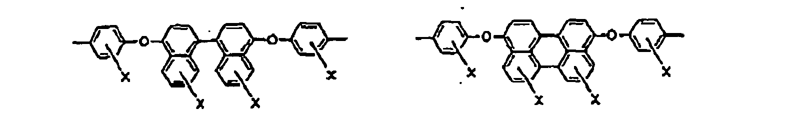 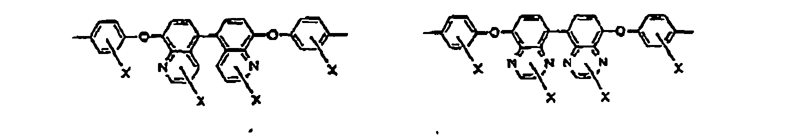 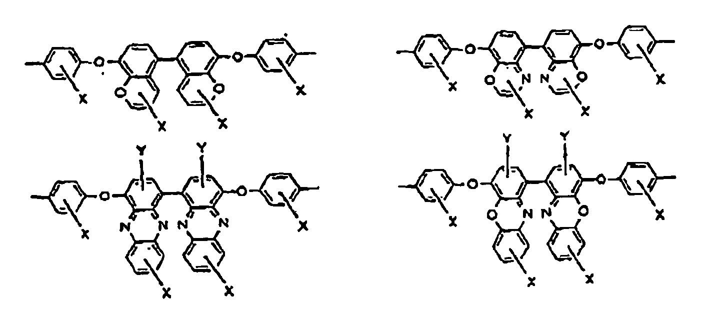 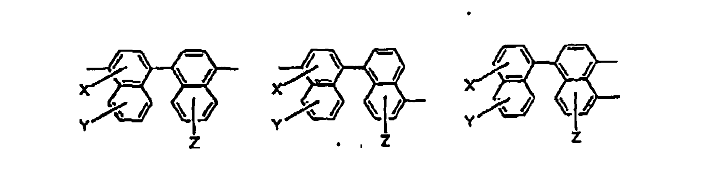 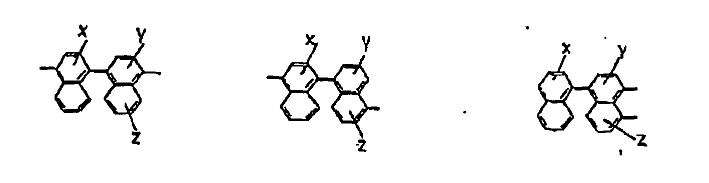 and where the substituents X, Y, Z are selected from the group consisting of hydrogen, halogen, oxygen and sulfur atoms, cyanoalkyl, alkyl, alkoxy, arylalkyl, sulfoxyl, sulfonyl and trifluoromethyl groups.

2. Arrangement according to Claim 1, **characterised in that** the compound has a structure of the following formula:

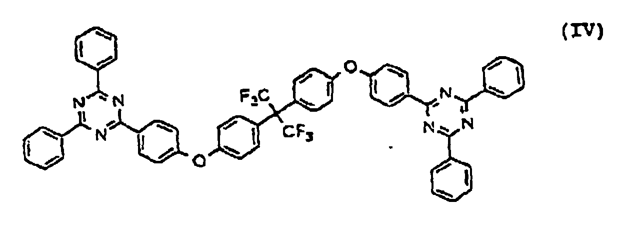

3. Arrangement according to one of the preceding claims, **characterised in that** the light-emitting layer system consists of three layers.

4. Arrangement according to one of the preceding claims, **characterised in that** the light-emitting layer system consists of a hole-conducting layer, an emitter layer and an electron-conducting layer.

5. Arrangement according to one of the preceding claims, **characterised in that** the hole-conducting layer comprises or consists of 4,4'-dimethoxy-TPD (D TPD) of the following formula:

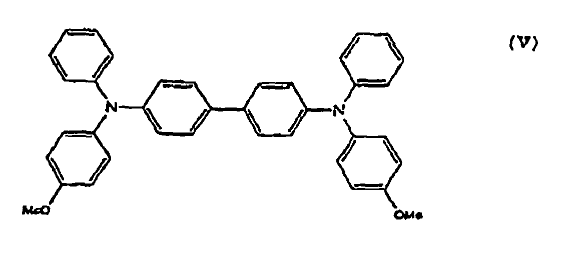

6. Arrangement according to one of the preceding claims, **characterised in that** the hole-conducting layer comprises or consists of EFTP of the following formula:

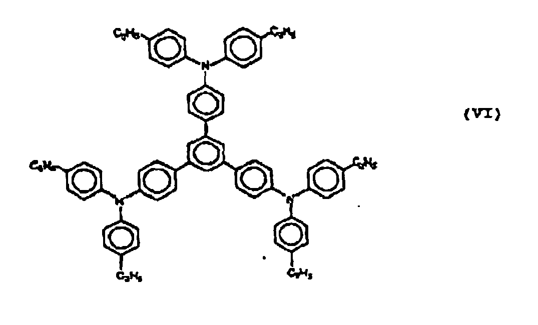

7. Arrangement according to one of the preceding claims, **characterised in that** the emitter layer comprises or consists of a photoluminescent substance, in particular a fluorescent dye.

8. Arrangement according to one of the preceding claims, **characterised in that** the emitter layer comprises or consists of aluminium(III) tris(8-hydroxyquinolate) of the following formula:

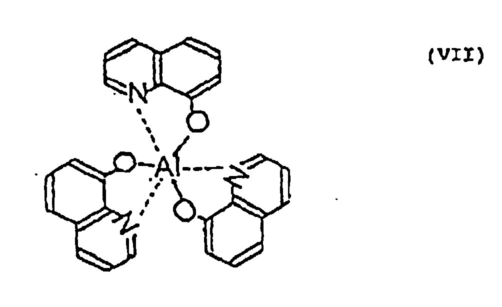

9. Arrangement according to one of the preceding claims, **characterised in that** the layer system is on a substrate.

10. Arrangement according to one of the preceding claims, **characterised in that** the substrate is a glass substrate.

11. Arrangement according to one of the preceding claims, **characterised in that** the anode comprises or consists of indium tin oxide.

12. Arrangement according to one of the preceding claims, **characterised in that** the cathode comprises or consists of aluminium and/or Mg/Ag and/or indium.

## Revendications

1. Agencement électroluminescent comprenant au moins deux électrodes et un système de couche émettrice de lumière comprenant au moins une couche de conduction d'électrons, dans lequel la couche de conduction d'électrons comprend ou est constituée d'au moins un composé ayant un squelette triazine, **caractérisé en ce que** le composé a une structure de la formule générale (II) ou (III) : 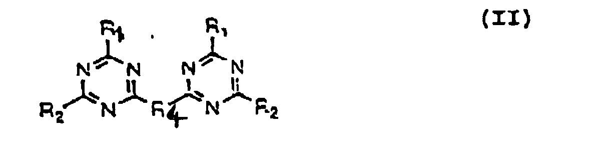 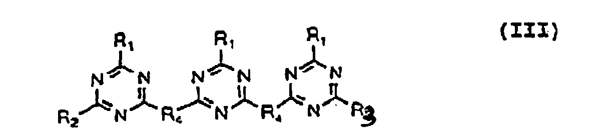 dans laquelle les radicaux organiques R₁, R₂ et R₃ sont choisis parmi le groupe de composés suivants : 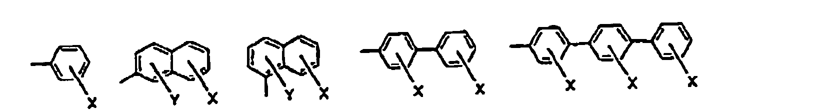 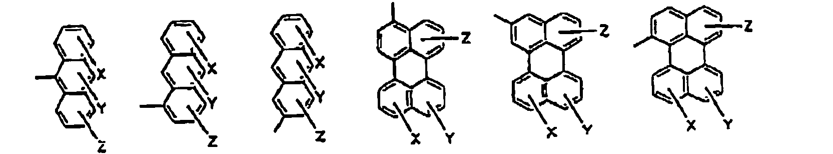 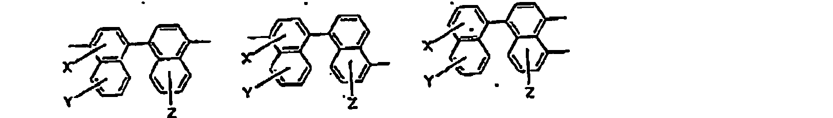 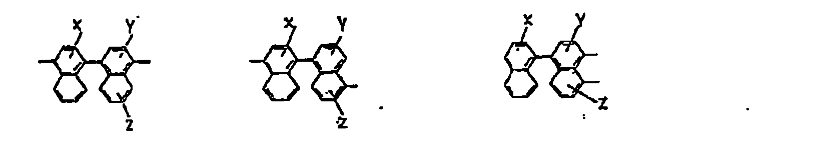 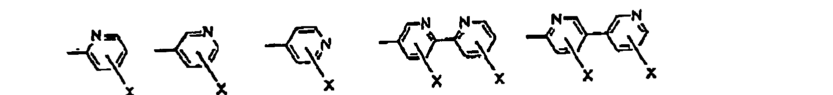 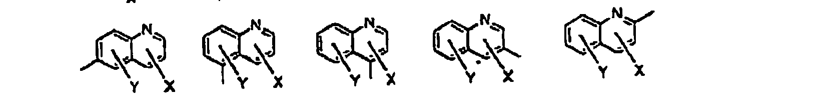 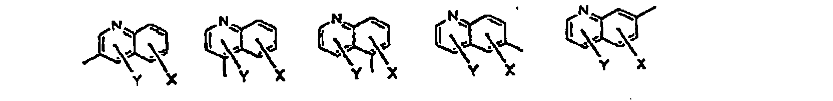 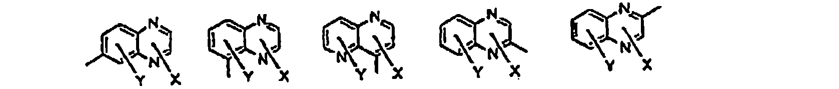 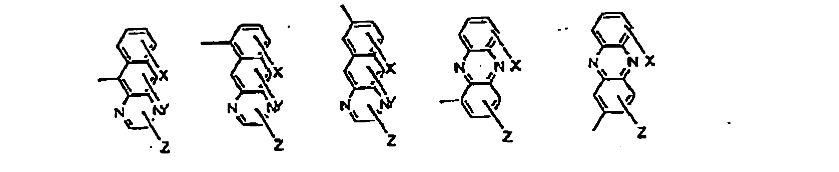 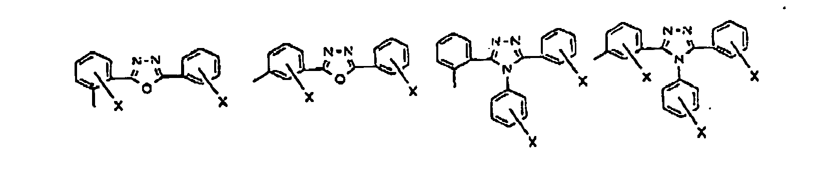 et dans laquelle R₄ est choisi parmi le groupe de composés : 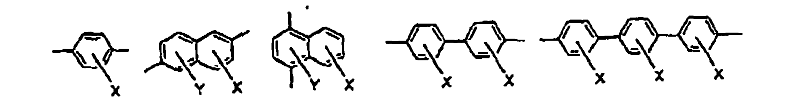 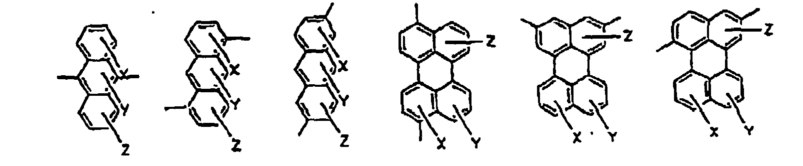 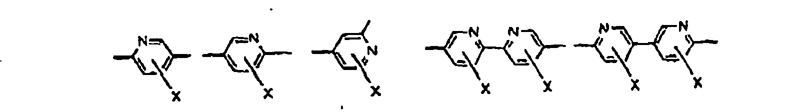 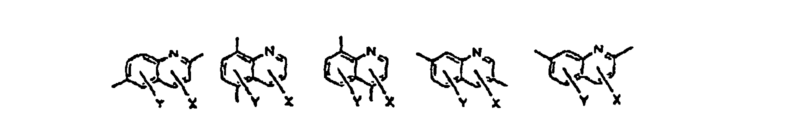 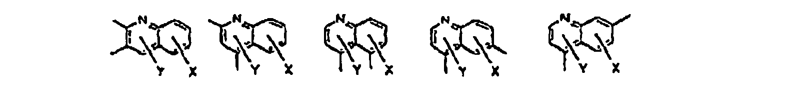 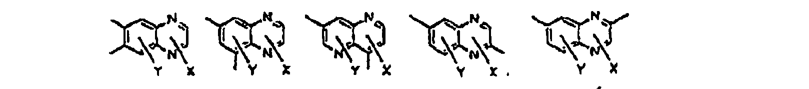 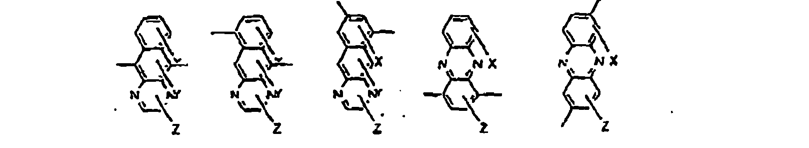 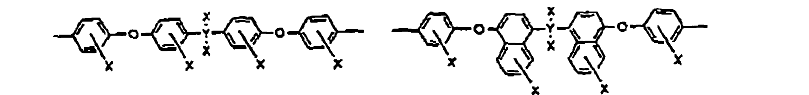 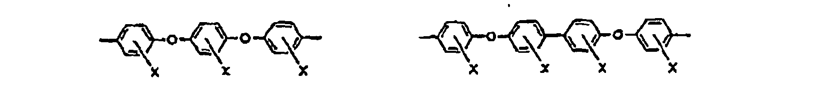 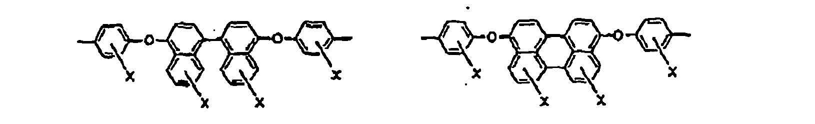 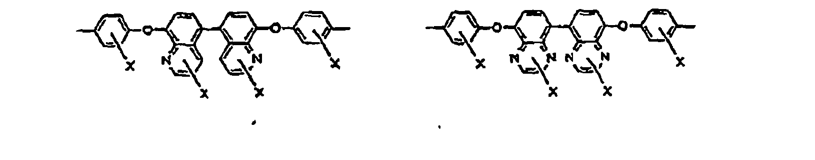 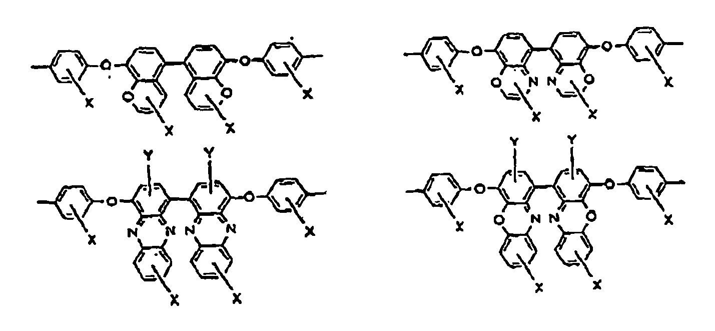 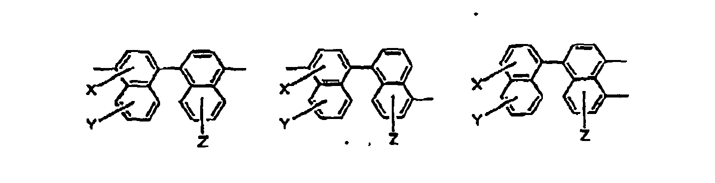 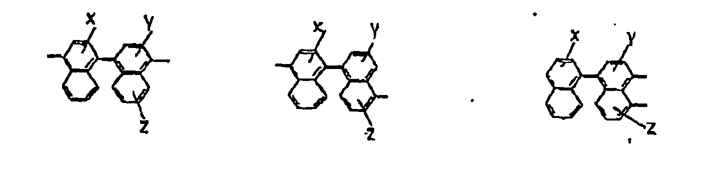 et dans lesquels les substituants X, Y, Z sont choisis parmi le groupe constitué des atomes d'hydrogène, d'halogène, d'oxygène et de soufre, des groupes cyanoalkyle, alkyle, alcoxy, arylalkyle, sulfoxyle, sulfonyle et trifluorométhyle.

2. Agencement selon la revendication 1, **caractérisé en ce que** le composé a une structure de la formule suivante :

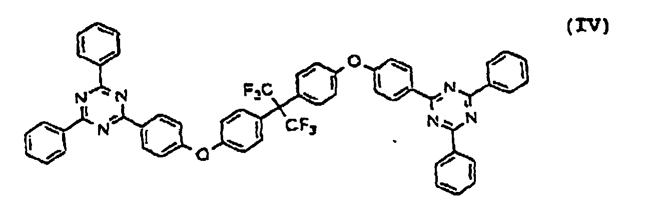

3. Agencement selon l'une des revendications précédentes, **caractérisé en ce que** le système de couche émettrice de lumière est constitué de trois couches.

4. Agencement selon l'une des revendications précédentes, **caractérisé en ce que** le système de couche émettrice de lumière est constitué d'une couche de conduction de trous, d'une couche d'émetteur et d'une couche de conduction d'électrons.

5. Agencement selon l'une des revendications précédentes, **caractérisé en ce que** la couche de conduction de trous comprend ou est constituée de 4,4'-diméthoxy-TPD (D TPD) de la formule suivante :

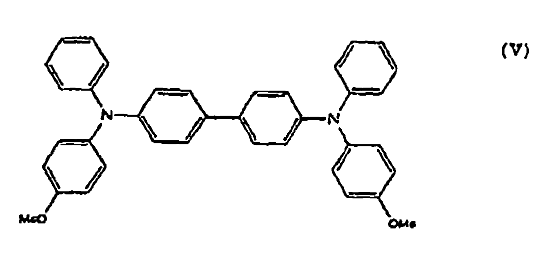

6. Agencement selon l'une des revendications précédentes, **caractérisé en ce que** la couche de conduction de trous comprend ou est constituée de EFTP de la formule suivante :

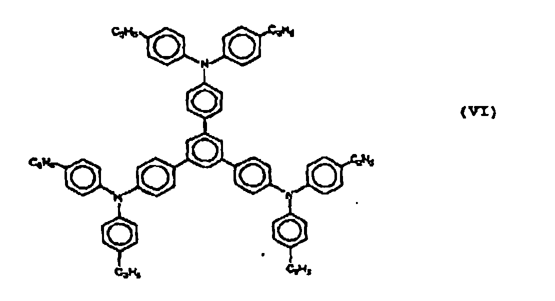

7. Agencement selon l'une des revendications précédentes, **caractérisé en ce que** la couche d'émetteur comprend ou est constituée d'une substance photoluminescente, en particulier un colorant fluorescent.

8. Agencement selon l'une des revendications précédentes, **caractérisé en ce que** la couche d'émetteur comprend ou est constituée d'aluminium(III) tris(8-hydroxyquinolate) de la formule suivante :

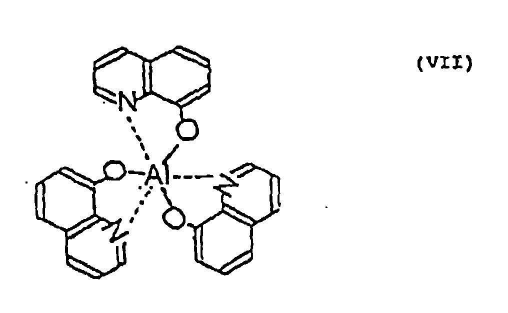

9. Agencement selon l'une des revendications précédentes, **caractérisé en ce que** le système de couche est sur un substrat.

10. Agencement selon l'une des revendications précédentes, **caractérisé en ce que** le substrat est un substrat en verre.

11. Agencement selon l'une des revendications précédentes, **caractérisé en ce que** l'anode comprend ou est constituée d'oxyde d'indium et d'étain.

12. Agencement selon l'une des revendications précédentes, **caractérisé en ce que** la cathode comprend ou est constituée d'aluminium et/ou de Mg/Ag et/ou d'indium.
